(19) Europäisches Patentamt

European Patent Office

Office européen des brevets

(11) **EP 0 851 378 B1**

(12) **EUROPEAN PATENT SPECIFICATION**

(45) Date of publication and mention
of the grant of the patent:
**10.03.2004 Bulletin 2004/11**

(51) Int Cl.$^7$: **G06K 7/10**

(21) Application number: **96830660.5**

(22) Date of filing: **30.12.1996**

(54) **Method and device for measuring and regulating a time constant of an electronic circuit forming part of an optical code reader**

Verfahren und Vorrichtung zum Messen und Regulieren einer Zeitkonstanten einer elektronischen Schaltung, die Teil eines optischen Kodelesers ist

Procédé et dispositif de mesure et régulation d'une constante de temps d'un circuit électronique formant partie d'un lecteur optique de code

(84) Designated Contracting States:
**AT BE CH DE DK ES FR GB IT LI NL PT SE**

(43) Date of publication of application:
**01.07.1998 Bulletin 1998/27**

(73) Proprietor: **DATALOGIC S.p.A.**
**40012 Lippo di Calderara di Reno (Bologna) (IT)**

(72) Inventors:
 • **Bianchi, Maurizio**
  **40126 Bologna (IT)**
 • **Piva, Marco**
  **61010 Maciano di Pennabilli (IT)**

(74) Representative: **Bottero, Claudio et al**
 **Porta, Checcacci & Associati S.p.A.**
 **Viale Sabotino, 19/2**
 **20135 Milano (IT)**

(56) References cited:
 **EP-A- 0 163 333**     **EP-A- 0 369 793**
 **EP-A- 0 421 423**     **EP-A- 0 469 305**
 **EP-A- 0 549 354**     **FR-A- 2 673 739**
 **US-A- 5 245 646**     **US-A- 5 396 053**
 **US-A- 5 550 362**

**Description**

The present invention relates to a method and device for defocusing an optical code reader.

Currently used high-resolution optical code readers require high-quality printing of the optical code, which is frequently misinterpreted by high-resolution readers if printed poorly, e.g. using matrix or ink jet printers.

To solve the above problem, high-resolution readers may be connected to optical defocusing devices normally comprising movable lenses, but which are expensive and slow-operating, due to the mechanical movements involved in the defocusing process.

It is therefore an object of the present invention to provide a defocusing method and device designed to overcome the aforementioned drawbacks.

US-A-5 396 053 discloses an adaptive method and system for reading bar codes symbols including a scanner for generating a light beam directed toward a target and sweeping the bar code symbol to be read and a photodetector for receiving the reflected light from such symbol. Processing circuitry are provided for determining whether the signal received represents a valid symbol.
The processing circuitry has adjustable gain, bandwidth and digitizer threshold characteristics which are set during the manufacturing process.
EP-A-0 369 793 discloses a bar code reading method and device for reading thin and thick bar codes. The device comprises a light receiving unit, a cut-off frequency switching amplifier and a CPU for controlling the amplifier. The amplifier has two cut-off frequencies which are switchable by the CPU depending on whether the bar code is a thin bar code or a thick bar code.
EP-A-0 469 305, from which the claims of the present invention are delimited, discloses a scanner that automatically adapts to varying scanning conditions without operator intervention. The scanner comprises a cut-off filter having two cut-off frequencies which are switchable depending on whether or not the code is recognized to be a high-density or low-density bar code.
FR-A-2 673 739 discloses an optical code reader similar to the one of EP-A-0 469 305, this reader also comprising a cut-off filter having two cut-off frequencies which are switchable depending on whether or not the code is recognized.

According to the present invention, there is provided a method of reading an optical code as claimed in claim 1 and an optical code reader as claimed in claim 7.

There is therefore provided a method and reader, which provide for variable focusing by applying a low-pass filter with a cutoff frequency which may be so varied as to electronically defocus the image, and which may be used in place of known optical defocusing devices to vary the focus of, and correctly interpret, the code, even in the event the code is badly printed.

A number of non-limiting embodiments of the present invention will be described by way of example with reference to the accompanying drawings, in which:

Figure 1 shows a block diagram of a device for measuring and regulating a time constant of an electronic circuit forming part of an optical code reader, but is not in accordance with the teachings of the present invention;

Figure 2 shows a circuit diagram of a first block of the Figure 1 device;

Figure 3 shows a circuit diagram of a second block of the Figure 1 device;

Figure 4 shows a circuit diagram of a further arrangement of the first block in Figure 2;

Figure 5 shows a block diagram of a further arrangement of the Figure 1 device;

Figure 6 shows a block diagram of a device for defocusing a signal of an optical bar code reader, in accordance with the teachings of the present invention;

Figure 7 shows a circuit diagram of a first block of the Figure 6 device;

Figures 8a, 8b show a block diagram of the operating cycle of the Figure 6 device;

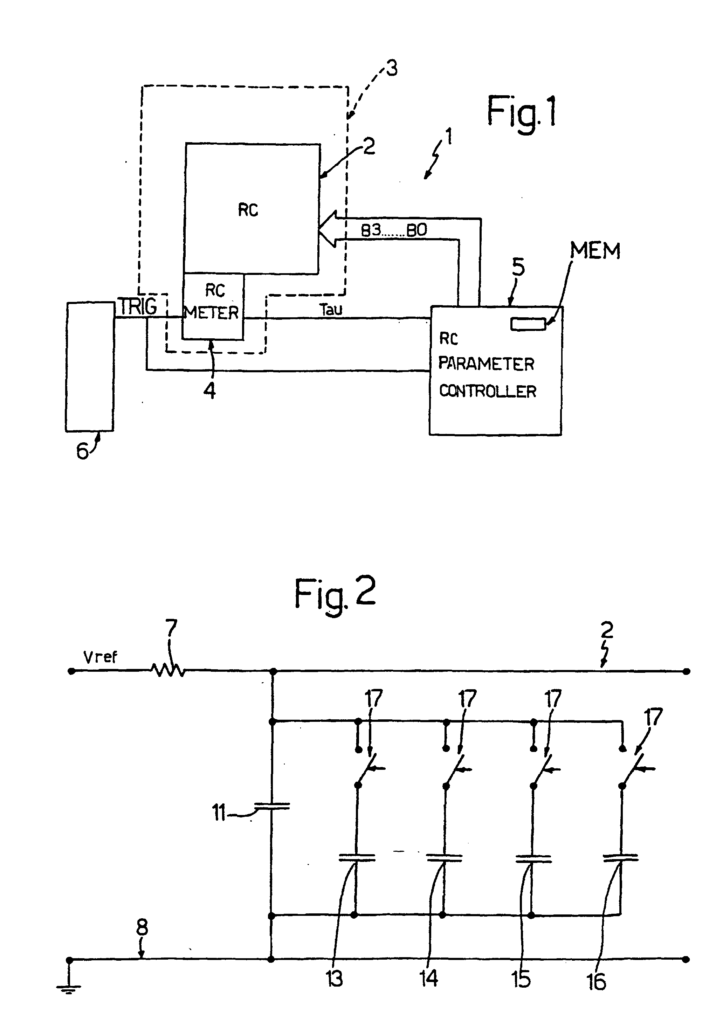

Table 1 shows a value correcting method used in the Figure 1 device;

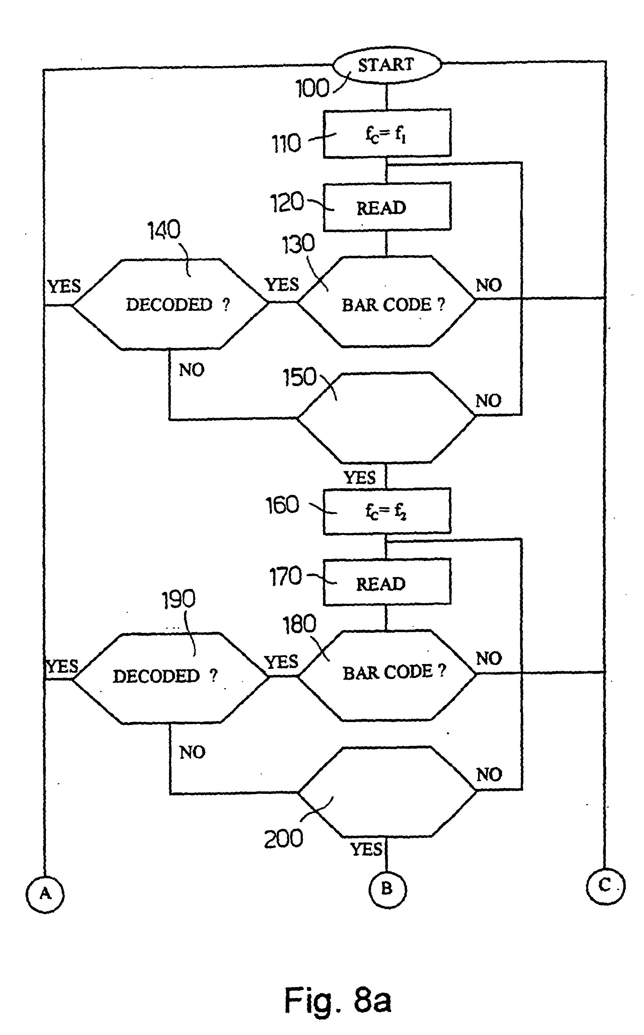

Table 2 shows the value correcting methods used in the Figure 6 device.

Number 1 in Figure 1 indicates a device for measuring and regulating the time constant $\tau$ of a block 2 comprising resistive and capacitive components defining a time constant $\tau = RC$ on the basis of respective resistance R and capacitance C values.

More specifically, block 2 may form part of an electronic circuit 3, in turn forming part, for example, of an optical code reader (not shown in Figure 1).

The term "optical code" is intended to mean a set of graphic marks applied to a label or directly on an object (or any other type of support), and whereby information is coded in the form of a sequence of black and white or variously coloured portions arranged in one or more directions. Such codes include, for example, bar codes, two-dimensional codes and colour codes.

Device 1 comprises a measuring block (RC METER) 4 cooperating with, and for measuring the time constant $\tau$ of, block 2; a control block (RC PARAMETER CONTROLLER) 5 receiving signals from measuring block 4 and supplying control signals to block 2; and a control block 6 for controlling blocks 4 and 5.

Figure 2 shows a circuit diagram of block 2, which comprises passive electronic components preferably formed on a silicon chip by means of known techniques. More specifically, block 2 comprises a resistor 7 with a first terminal connected to a positive reference voltage Vref, and a second terminal connected to a reference voltage (ground) 8 via a main capacitor 11; and a number of secondary capacitors 13, 14, 15, 16, each with a first terminal connected to ground 8, and a second terminal connected to the second terminal of resistor 7 via a respective switch 17 controlled by control block 5.

Main capacitor 11 has a much higher capacitance value than any of secondary capacitors 13-16, which all have different capacitance values.

Switches 17 provide for connecting or disconnecting respective secondary capacitors 13, 14, 15, 16 to or from the parallel connection with main capacitor 11, so that the main capacitance defined by capacitor 11 may be increased by closing switches 17. Block 2 (resistive-capacitive type) therefore defines a time constant, and comprises a resistive component of fixed resistance, and a capacitive component, the capacitance of which is adjustable on the basis of control signals B3...BO (Figure 1) from control block 5.

The actual resistance and capacitance values R and C of a resistor and capacitor are known to be defined by:

$$R = Rn.Kr$$

where Rn is the nominal resistance value, and Kr a parameter which takes into account the nominal value error, which (depending on the technique used) may be as high as $\pm20\%$ of the nominal value (i.e. Kr = 0.8-1.2); and by:

$$C = Cn.Kc$$

where Cn is the nominal capacitance value, and Kc a parameter which takes into account the nominal value error, which (depending on the technique used) may be as high as $\pm20\%$ of the nominal value (i.e. Kc = 0.8-1.2).

The product R.C (time constant) may therefore be expressed as follows:

$$R.C = (Rn.Kr).(Cn.Kc)=Rn.Cn.Ke \qquad (1)$$

where parameter Ke equals Kr.Kc (Ke may vary between 0.64 and 1.44), is related to the error between the nominal and the real time constant value, and depends on temperature and the component tolerances.

To achieve a constant value of time constant $\tau$, product R.C must equal product Rn.Cn, i.e. R.C = Rn.Cn (1).

More specifically, if the time constant is obtained using a variable capacitor (as-in block 2) with a capacitance value Cv = Cnv.Kc (where Cnv is the nominal capacitance value, and Kc takes into account the nominal value error), the time constant will depend on the product R.Cv, so that, to achieve a constant value of time constant $\tau$, product R.Cv must equal product Rn.Cn.

Put explicitly:
R.Cv = Rn.Cn i.e.
Rn.Cnv.Ke = Rn.Cn which gives
Cnv = Cn/Ke (2)

By appropriately setting variable capacitance value Cnv, equation (2) may therefore be met to maintain a constant value of time constant $\tau$.

More specifically, by varying the capacitance of capacitor 11 in block 2 (i.e. by controlling which secondary capacitors 13, 14, 15, 16 are to be connected parallel to main capacitor 11), a Cnv value can be obtained to meet equation (2) so that R.Cv = Rn.Cn = constant.

The variable capacitance value Cnv = Cn/Ke to be achieved in block 2 is therefore calculated on the basis of value Cn and parameter Ke. Whereas Cn (nominal capacitance value - of capacitor 11) is known, the value of parameter Ke must be measured.

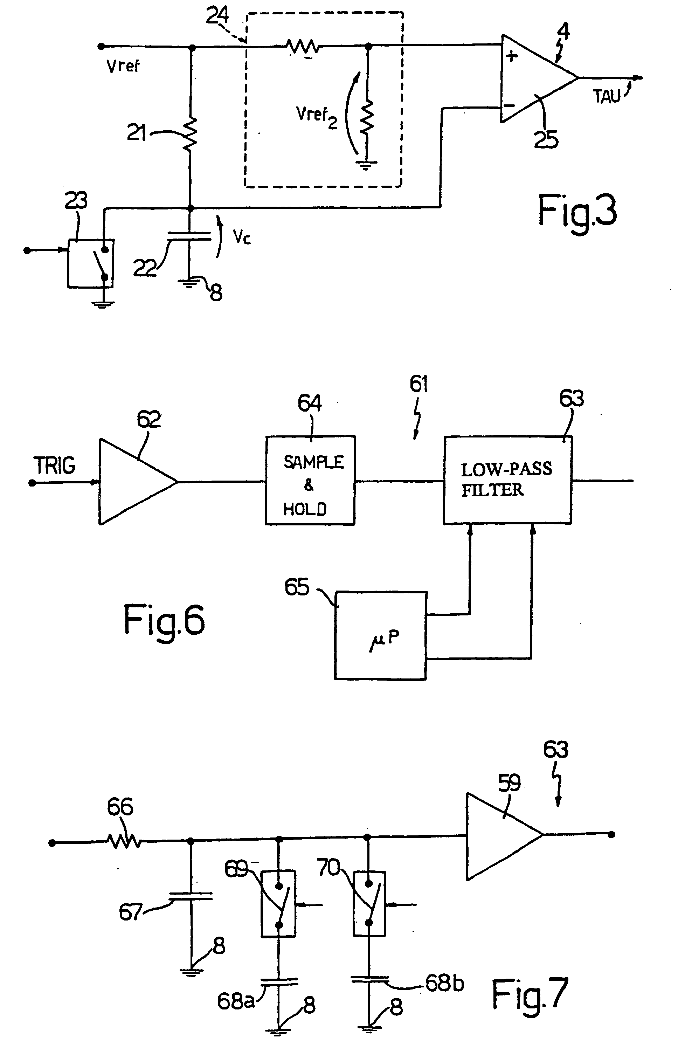

Figure 3 shows a circuit diagram of measuring block 4, which provides for measuring parameter Ke, or rather, for indirectly measuring the value of a parameter Ke of substantially the same value as parameter Ke.

More specifically, as opposed to being performed directly on the resistive and capacitive components (resistor 7 and capacitor 11) defining the time constant in block 2, the measurement in block 4 is performed indirectly on other resistive and capacitive components similar to those defining the time constant in block 2, and located on the same chip as block 2. As similar components formed on the same chip are known to have fairly small tolerances (normally in the region of 1.5% at the most), the resistive and capacitive components of block 4 therefore closely approximate those of block 2, while both blocks 2 and 4, which are formed closely contacting each other on the same physical support, are affected in exactly the same way by temperature.

With reference to Figure 3, block 4 comprises a sample resistor 21 of resistance Rm, with a first terminal connected to said reference voltage Vref, and a second terminal connected to said reference ground 8 via a sample capacitor 22 of capacitance Cm. A switch 23, controlled by block 6 by means of a trigger signal TRIG, is connected parallel to capacitor 22. The first terminal of resistor 21 is connected, via a resistive voltage divider 24, to the noninverting (+) input terminal of a comparing circuit 25 comprising, for example, an operational amplifier, and the second terminal of resistor 21 is connected to the inverting terminal of comparing circuit 25, so that a reference voltage Vref2 formed by divider 24 is applied to the noninverting terminal of comparing circuit 25, and the voltage Vc of capacitor 22 is applied to the inverting (-) terminal.

When switch 23 is opened, capacitor 22 (which was formerly shorted and therefore discharged) begins charging via resistor 21. When the difference in potential at the terminals of capacitor 22 equals the reference voltage defined by divider 24, comparing circuit 25 switches and changes output voltage TAU from a positive value to zero. The instant switching occurs depends on the product RmCm, the value of which varies according to temperature and the tolerance of the components. As stated, inside the chip, block 4 is located in close contact with block 2, and the resistive and capacitive components (resistor 21 and capacitor 22) in block 4 are the same type as those (resistor 7 and capacitor 11) in block 2, so that, except for a small difference due to technological spread (spread error), error Ke measured relative to Rm and Cm equals that of R and Cv in block 2, and measuring Ke of block 4 is tantamount to measuring Ke in block 2.

More specifically, the time interval t is measured between the instant switch 23 opens and the instant comparing circuit 25 switches; which time interval t, as stated, is related to Cm and Rm.

As the value of Ke is also related linearly to the value of time interval t, Ke is easily calculated by simply measuring time interval t and providing a bijective map (Table 1) assigning a corresponding Ke value to each measured t value.

For each calculated Ke value, Table 1 also comprises capacitance value Cvn, which, on the basis of equation (2), provides for satisfying equation (1).

In forming Table 1, the capacitance values of secondary capacitors 11-16 and capacitance value Cn of main capacitor 11 are fixed, and a number of predetermined time intervals are defined and arranged, as shown in Table 1, along the time axis where t=0 at the trigger instant (the instant switch 23 is opened). Each time interval t value is assigned a Ke value, which in turn is related to a theoretical value Cnvt of the variable capacitance in block 2, calculated according to equation (2) and providing for complete correction. Each Ke interval is also assigned a Cnv value physically achievable by the capacitors in block 2, and which provides for minimizing the error due to quantizing Cvnt. In fact, combining the capacitances of capacitors 11, 13, 14, 15 and 16 only provides for setting a predetermined number of discrete capacitive values, and always results in a quantizing error with respect to the theoretical value calculated according to equation (2); which quantizing error would be eliminated if the Cnv value were variable continuously.

In particular, if value t is below the nominal value Ten (i.e. below the value which would be achieved if there were no errors in the definition of the time constant), the capacitance value is increased (by adding capacitance in parallel with capacitor 11). Conversely, capacitance is reduced.

Physically, Table 1 may comprise, for example, a memory MEM (shown schematically in Figure 1), which is addressed by means of an input signal indicating the value of time interval t, and which supplies, for each input signal value, a respective parameter Ke value and a respective value of capacitance Cvn physically achievable to satisfy equation (1). The Cvn value supplied by the memory (not shown) is read by control block 5 and used to so operate switches 17 that capacitor 11, together with parallel capacitors 13-16, produces the desired Cvn value.

A method is therefore provided for measuring and regulating a time constant ($\tau$) of an electronic circuit forming part of an optical reader and 'comprising resistive and capacitive components defining said time constant on the basis of respective resistance (R) and capacitance (C) values; characterized by comprising the steps of:

- forming at least one of said resistive and capacitive components of adjustable value;
- measuring the value of the time constant of said circuit by determining at least one error parameter (Ke) related to the error between the nominal value of said time constant and the real value of the measured time constant; and
- modifying the value of said component of adjustable value on the basis of at least said error parameter (Ke) to maintain the time constant of said circuit at a substantially constant value.

The above procedure may be performed when initially calibrating electronic circuit 3, to compensate for the component tolerances, or periodically to compensate for any variations due to temperature.

If electronic circuit 3 forms part of an optical reader, the above procedure may be performed periodically, e.g. prior to each bar code reading.

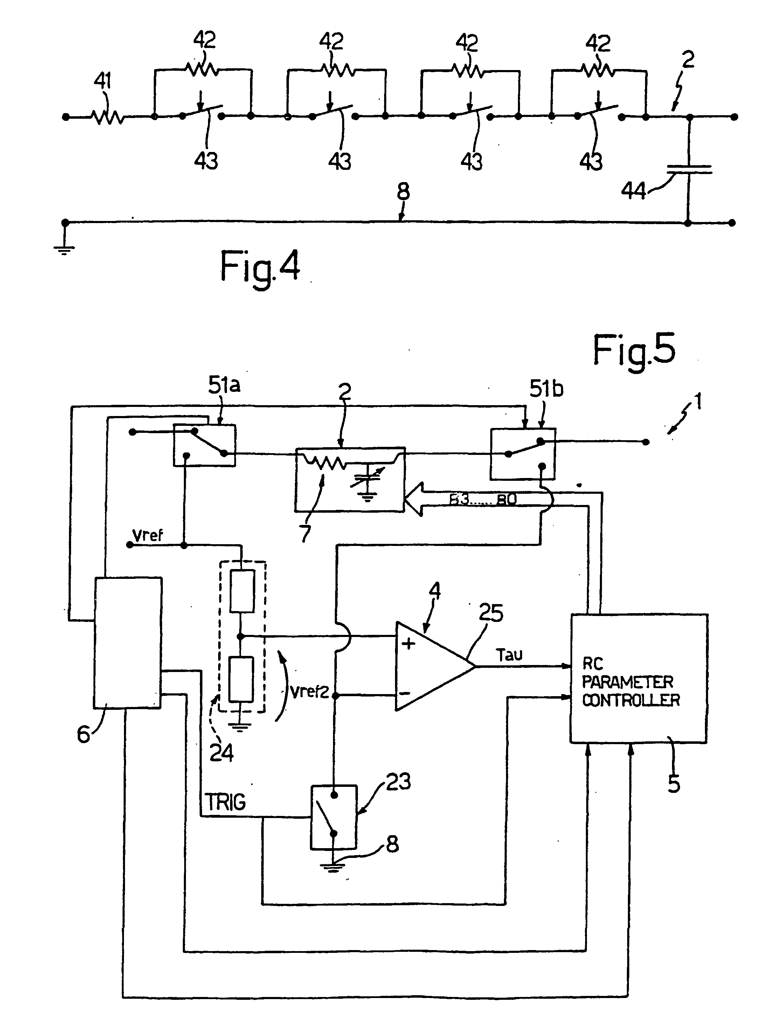

Figure 4 shows a circuit diagram of an alternative block 2 to the one in Figure 2, and which only differs by defining a variable resistance Rv connected to a fixed capacitance, as opposed to defining a variable capacitance Cv.

More specifically, block 2 in Figure 4 comprises a main resistor 41, and a number of secondary resistors 42 in series with main resistor 41 and having respective switches 43 controlled by control block 5. When closed, each switch 43 shorts the respective resistor 42 to which it is connected in parallel, to disconnect resistor 42 from the series connection with resistor 41. The last resistor 42 in the series (the one furthest away from resistor 41) is connected to a first terminal of a capacitor 44 having a second terminal connected to ground 8.

Switches 43 are controlled by block 5, which therefore determines the configuration of block 2 to achieve a predetermined total resistance value.

A measuring and regulating procedure similar to the one described above may also be applied to block 2 in Figure 4 by configuring a group of resistors as opposed to a group of capacitors.

Use may obviously also be made of a block 2 (not shown) for configuring groups of both resistors and capacitors.

Figure 5 shows a device 1 in which blocks 2 and 4 are even further integrated.

The Figure 5 configuration may be used to advantage in the event the spread-induced error of the discrete components defining the time constant is substantially of the same order as the component tolerances. In which case, in fact, measuring parameter Ke by means of measuring block 4 would be of no significance, owing to the real error parameter values in block 2 not being sufficiently equal to those evaluated by block 4. The Figure 5 configuration may also be used, however, in the event the components are formed on the same chip.

More specifically, the input of block 2 (first terminal of resistor 7) is connected to the common terminal of a switch 51a operated by control block 6 and having a first input communicating with circuit 3, and a second input connected to reference voltage Vref. The output of block 2 (second terminal of resistor 7) is connected to the common terminal of a switch 51b operated by control block 6 and having a first input communicating with circuit 3, and a second input connected to the inverting (-) input of comparator 25 of measuring block 4. The noninverting (+) terminal of comparator 25 receives the reference voltage Vref2 produced by resistive divider 24 supplied with reference voltage Vref; and switch 23 is located between ground 8 and the inverting (-) terminal of comparator 25.

By means of switches 51a, 51b controlled by block 6, block 2 may therefore be disconnected from circuit 3 and used (when measuring Ke) in block 4 in place of resistor 21 and capacitor 22.

In other words, at the measuring step, the block 2 components are used directly by block 4 to measure the time constant. And, as described previously, time interval t is measured to calculate the capacitance Cvn which must be defined in block 2 to meet equation (2). More specifically, if t is below the nominal value (i.e. the exact value which would be achieved if there were no errors in the definition of the time constant), the capacitance value is increased (by adding capacitance in parallel, as described previously). Conversely, capacitance is reduced.

The Figure 5 circuit may also operate in successive time phases, in which time constant measuring and regulating phases (of time t1) alternate with normal operating phases (of time t2) in which the previously regulated time constant is used. Value t2 of the normal operating phases is greater than t1 of the measuring phases.

Device 1 in Figure 5 obviously eliminates any spread-induced errors, and the control logic is more straightforward.

The advantages of the above method and of device 1 implementing such a method will be clear from the foregoing description.

In particular, the method provides for calibrating the product RC of all similar electronic circuits to the same value, and for maintaining product RC constant during use of the circuit to compensate for the sensitivity of the circuit to varying temperatures. If the circuit forms part of an optical reader, the above method ensures a similar interpretation of the optical code by all similar optical readers, and a constant interpretation of the code by each single reader.

Number 61 in Figure 6 indicates a device for varying the signal focus of an optical code reader (not shown), and which comprises an input amplifying block (INPUT STAGE) 62, a block 63 comprising a LOW-PASS FILTER, a sampling (SAMPLE & HOLD) block 64 located between blocks 62 and 63, and a microprocessor 65 for controlling block 63. Block 62 receives and amplifies the video signal generated by a CCD viewing device, and supplies the amplified signal, via SAMPLE & HOLD block 64, to filter 63, which generates and supplies an analog signal to a further processing chain (not shown) for automatically reading optical code images.

Figure 7 shows a circuit diagram of block 63, which is similar to block 2 in Figure 2 by also defining a variable time constant RC.

In this case, however, product R.C is varied to vary the cutoff frequency of the low-pass filter and control the focus of the analog signal supplied to the processing chain (not shown) of the automatic reading device.

As shown in Figure 7, block 63 comprises a resistor 66 having a first terminal forming the input of block 63, and a second terminal connected to a reference voltage (ground) 8 via a main capacitor 67; a number of secondary capacitors 68a, 68b, each of which has a first terminal connected to ground 8, and a second terminal connected to the second terminal of resistor 66 via a respective switch 69, 70 controlled by block 65; and an amplifier 59 having an input connected to the second terminal of resistor 66, and an output also forming the output of block 63.

Switches 69, 70 provide for connecting or disconnecting respective secondary capacitors 68a, 68b to or from the parallel connection with main capacitor 67, so that, when the switches are closed, capacitance may be added to the main capacitance defined by capacitor 67, and the cutoff frequency of filter 63 changed.

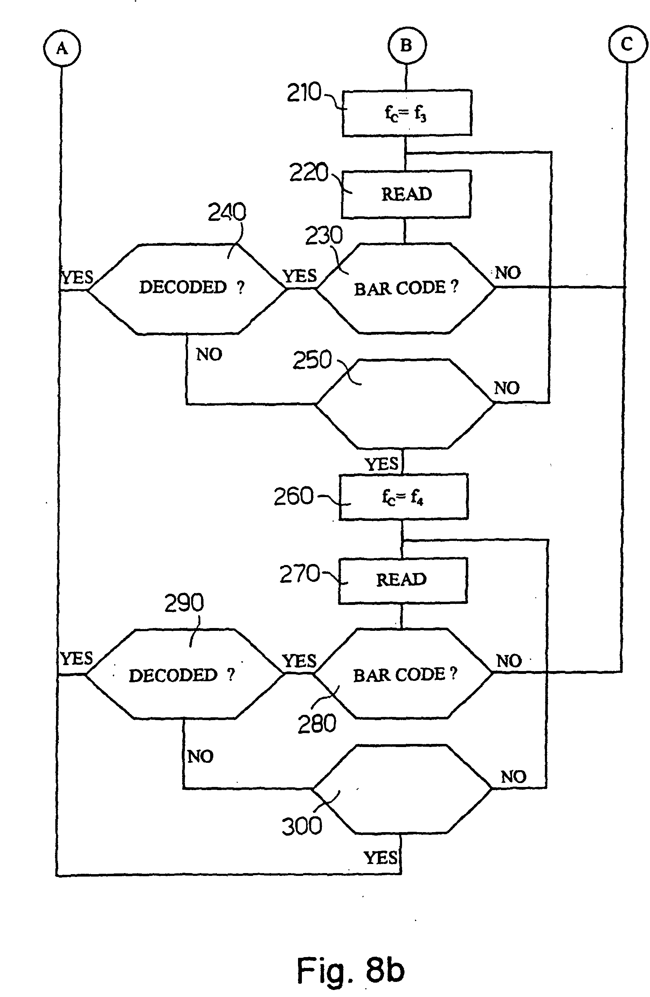

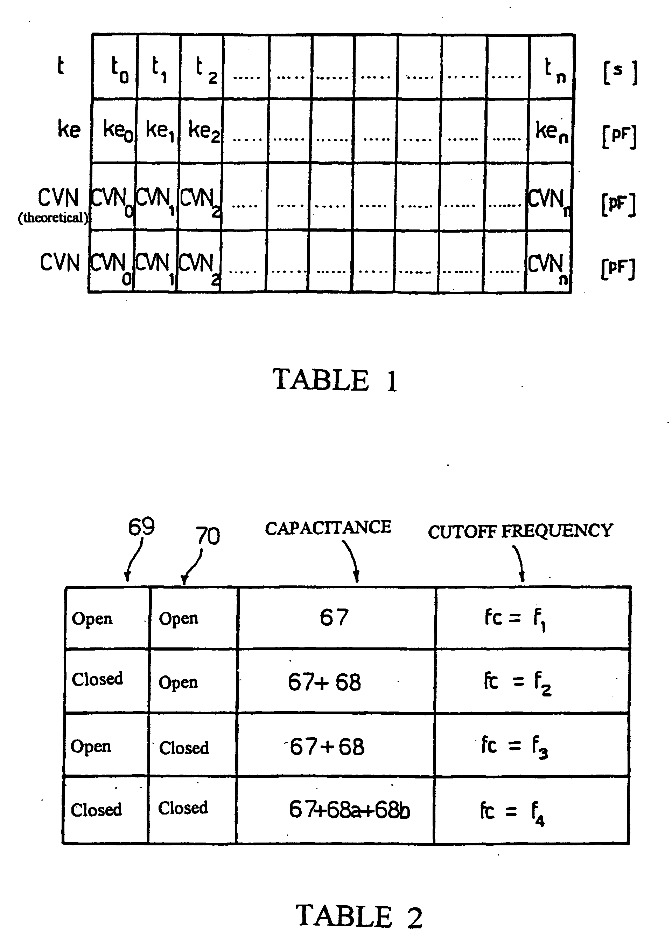

Figures 8a, 8b show the operating cycle, controlled by microprocessor 65, of device 61.

More specifically, a start block 100 is followed by a block 110 in which a first value f1 is set as the cutoff frequency fc of block 63; which value f1 is defined (Table 2) by resistor 66 connected solely to capacitor 67 (switches 69 and 70 are open, and capacitors 68a, 68b disconnected).

Block 110 is followed by a block 120, which commands a reading device (not shown) connected at the input to the output of block 63 to read the optical code.

Block 120 is followed by a block 130, which determines whether the image processed by the reading device may be considered an optical code image. In the event of a positive response (code image present), block 130 goes on to block 140. Conversely, block 130 goes back to block 100.

Block 140 determines whether the code has been decoded with the set cutoff frequency (fc = f1). In the event of a negative response (code not decoded), block 140 goes on to block 150. Conversely (code decoded), block 140 goes back to block 100. Block 150 determines whether a maximum number nl of consecutive read cycles with fc = f1 has been performed without the code image being decoded. In the event of a positive response (code image still not decoded despite being read nl times), block 150 goes on to block 160. Conversely, block 150 goes back to block 120 to perform a further read cycle.

In block 160, the cutoff frequency fc set in block 110 is changed to a second value f2 lower than f1, and which is obtained in block 63 (Table 2) by closing switch 69 connected to capacitor 68a, and leaving switch 70 connected to capacitor 68b open.

Block 160 is followed by block 170, which commands the reading device (not shown) to read an optical code.

Block 170 is followed by a block 180, which determines whether the image processed may be considered an optical code image. In the event of a positive response (code image present), block 180 goes on to block 190. Conversely, block 180 goes back to block 100.

Block 190 determines whether the code has been decoded with the new cutoff frequency (fc = f2). In the event of a negative response (code not decoded), block 190 goes on to block 200. Conversely (code decoded), block 190 goes back to block 100. Block 200 determines whether a maximum number n2 (where n2 < n1) of consecutive read cycles with fc = f2 has been performed without the code image being decoded. In the event of a positive response (code image still not decoded despite being read n2 times), block 200 goes on to block 210. Conversely, block 200 goes back to block 170 to perform a further read cycle.

In block 210, the cutoff frequency fc set in block 160 is changed to a third value f3 lower than f2, and which is obtained in block 63 (Table 2) by closing switch 70 connected to capacitor 68b, and opening switch 69 connected to capacitor 68a.

Block 210 is followed by block 220, which commands the reading device (not shown) to read an optical code.

Block 220 is followed by a block 230, which determines whether the image processed may be considered an optical code image. In the event of a positive response (code image present), block 230 goes on to block 240. Conversely, block 230 goes back to block 100.

Block 240 determines whether the code has been decoded with the further cutoff frequency (fc = f3). In the event of a negative response (code not decoded), block 240 goes on to block 250. Conversely (code decoded), block 240 goes back to block 100. Block 250 determines whether a maximum number n3 (where n3 ≤ n2) of consecutive read cycles with fc = f3 has been performed without the code image being decoded. In the event of a positive response (code image still not decoded despite being read n3 times), block 250 goes on to block 260. Conversely, block 250 goes back to block 220 to perform a further read cycle.

In block 260, the cutoff frequency fc set in block 210 is changed to a fourth value f4 lower than f3, and which is obtained (Table 2) by closing both switches 69 and 70 in block 63.

Block 260 is followed by block 270, which commands the reading device (not shown) to read an optical code.

Block 270 is followed by a block 280, which determines whether the image processed may be considered an optical code image. In the event of a positive response (code image present), block 280 goes on to block 290. Conversely, block 280 goes back to block 100.

Block 290 determines whether the code has been decoded with the further cutoff frequency (fc = f4). In the event of a negative response (code not decoded), block 290 goes on to block 300. Conversely (code decoded), block 290 goes back to block 100. Block 300 determines whether a maximum number n4 (where n4 ≤ n3) of consecutive read cycles with fc = f4 has been performed without the code image being decoded. In the event of a positive response (code image still not decoded despite being read n4 times), block 300 goes back to block 100. Conversely, block 300 goes back to block 270 to perform a further read cycle.

Blocks 180, 230 and 280 may be dispensed with by determining whether or not an optical code is being read only once at the start of the read process. More specifically, the first read step with a first maximum number n1 of repetitions is followed by a second read step with a second maximum number n2 of repetitions, the first number n1 being over twice the second number n2, i.e. n1>2n2; and the second, third and fourth successive read steps are performed respectively with second n2, third n3 and fourth n4 maximum numbers of repetitions, the second, third and fourth numbers of repetitions being substantially coincident.

The advantages of device 61 will be clear from the foregoing description.

In particular, there is provided a focus adjusting device by applying a low-pass filter with a variable, gradually decreasing cutoff frequency, so that, as opposed to using known optical defocusing devices, the bar code image is gradually defocused electronically, thus enabling a variation in the focus of the code, and correct interpretation of even badly printed codes.

## Claims

1. A method of reading an optical code, comprising the steps of:

   - supplying a data manipulating circuit (62,64) with an analog signal representing the optical code;
   - supplying signals from an output of said data manipulating circuit to a low-pass filter type data processing circuit (63), said data processing circuit cooperating at an output with automatic optical code reading means;
   - implementing (110) in said data processing circuit (63) a first value (f1) of a cutoff frequency (fc) of said low-pass filter;
   - performing (120) at least one read cycle of said optical code with said first value (f1) of the cutoff frequency; and
   - determining (140, 150) whether said optical code has been decoded, **characterized in that** said method further comprises, in the event said optical code has not been decoded:

     - updating (160) the cutoff frequency (fc) in said data processing circuit (63) and implementing a second value (f2) of the cutoff frequency (fc), said second value (f2) being lower than said first value (f1);
     - performing (170) at least one read cycle of said optical code with said second value (f2) of the cutoff frequency; and
     - determining (190, 200) whether said optical code has been decoded, and, in the event said optical code has not been decoded:

       - updating (210) the cutoff frequency (fc) in said data processing circuit (63) and implementing a third value (f3) of the cutoff frequency, said third value (f3) being lower than said second value (f2).

2. A method as claimed in Claim 1, **characterized by** comprising the steps of:

   - performing (220) at least one read cycle of said optical code with said third value (f3) of the cutoff frequency; and
   - determining (240, 250) whether said optical code has been decoded, and, in the event said optical code has not been decoded:

     - updating (260) the cutoff frequency (fc) in said data processing circuit (63) and implementing a fourth value (f4) of the cutoff frequency, said fourth value (f4) being lower than said third value (f3).

3. A method as claimed in Claim 1 or 2, **characterized in that** said performing steps (120, 170, 220, 270) and said determining steps (140, 150, 190, 200, 240, 250) comprise iteratively repeating the read cycle of said optical code with the respective cutoff frequency (fc) and checking whether said optical code has been decoded, and **in that**, when a respective maximum number (n1, n2, n3, n4) of read cycles of said code is reached without the code being decoded, said steps of updating (160, 210, 260) the cutoff frequency (fc) are executed.

4. A method as claimed in Claims 3, wherein said respective maximum numbers (n1, n2, n3, n4) of read cycles of said code have different decreasing values.

5. A method as claimed in Claims 1 and 4, **characterized in that** a first maximum number (n1) of read cycles is executed with said first value (f1) of the cutoff frequency and a second maximum number (n2) of read cycles is executed with said second value (f2) of the cutoff frequency; said first maximum number (n1) being over twice (n1>2n2) said second maximum number (n2).

6. A method as claimed in Claims 2 and 4, **characterized in that** a second maximum number (n2) of read cycles is executed with said second value (f2) of the cutoff frequency, a third maximum number (n3) of read cycles is executed with said third value (f3) of the cutoff frequency, and a fourth maximum number (n4) of read cycles is executed with said forth value (f4) of the cutoff frequency; said second, third and fourth maximum numbers being substantially equal one another.

7. An optical code reader comprising:

   - a data manipulating circuit (62,64) receiving an analog signal representing an optical code;
   - - a data processing circuit (63) receiving signals from an output of said data manipulating circuit, and supplying a processed signal to automatic optical code reading means;

     said data processing circuit (63) comprising resistive (66) and capacitive (67, 68a, 68b) components defining a low-pass filter;

   - control means (65) for controlling said data processing circuit (63) to regulate a cutoff frequency (fc) of said low-pass filter, said control means (65) comprising:

     - setting means (110) for implementing in said data processing circuit (63) a first value (f1) of said cutoff frequency (fc) of said low-pass filter;

- reading means (120) for performing at least one read cycle of said optical code with said first value (f1) of said cutoff frequency; and
- checking means (140, 150) for determining whether said optical code has been decoded; **characterized by** said checking means, in the event said optical code has not been decoded, selecting updating means (160) for modifying the cutoff frequency (fc) in said data processing circuit (63) and implementing a second value (f2) of the cutoff frequency, said second value (f2) being lower than said first value (f1);

said control means (65) further comprising:

- reading means (170) for performing at least one read cycle of said optical code with said second value (f2) of the cutoff frequency;
- checking means (190, 200) for determining whether said optical code has been decoded; said checking means, in the event said optical code has not been decoded, selecting updating means (210) for modifying the cutoff frequency (fc) in said data processing circuit (63) and implementing a third value (f3) of the cutoff frequency, said third value (f3) being lower than said second value (f2).

8. A reader as claimed in Claim 7, **characterized in that** said control means (65) further comprise:

- reading means (220) for performing at least one read cycle of said optical code with said third value (f3) of the cutoff frequency;
- checking means (240, 250) for determining whether said optical code has been decoded; said checking means, in the event said optical code has not been decoded, selecting updating means (260) for modifying the cutoff frequency (fc) in said data processing circuit (63) and implementing a fourth value (f4) of the cutoff frequency, said fourth value (f4) being lower than said third value (f3).

9. A reader as claimed in claim 7 or 8, comprising repeating means (150, 200, 250, 300) for iteratively repeating the read cycle of said optical code with the respective set cutoff frequency and, in the event said code has not been decoded, when a respective maximum numbers (n1, n2, n3, n4) of read cycle of said code is reached without the code being decoded, selecting said updating means (160, 210, 260) for modifying the cutoff frequency (fc).

10. A reader as claimed in any of Claims from 7 to 9, **characterized in that** said control means are microprocessor control means.

11. A reader as claimed in any of the Claims from 7 to 10, **characterized in that** said data processing circuit (63) comprises resistor means (66) having a first terminal communicating with the output of said data manipulating circuit (62), and a second terminal connected to at least one main capacitor (67); said data processing circuit comprising at least one secondary capacitor (68a, 68b) connectable parallel to said main capacitor (67), and switching means (69, 70) operated by said control means (65) to connect or disconnect said secondary capacitor (68a, 68b) to or from the parallel connection with said main capacitor (67) and modify said cutoff frequency (fc).

## Patentansprüche

1. Verfahren zum Lesen eines optischen Codes, das die Schritte aufweist:

- Zuführen eines analogen Signals, das den optischen Code repräsentiert, zu einer Datenmanipulationsschaltung (62, 64);
- Zuführen von Signalen von einem Ausgang der Datenmanipulationsschaltung zu einer Datenverarbeitungsschaltung (63) eines Tiefpaßfiltertyps, wobei die Datenverarbeitungsschaltung an einem Ausgang mit einer automatischen optischen Codeleseinrichtung zusammenwirkt;
- Implementieren (110) eines ersten Wertes (f1) einer Abschneidefrequenz (fc) des Tiefpaßfilters in der Datenverarbeitungsschaltung (36);
- Ausführen (120) zumindest eines Lesezyklus des optischen Codes mit dem ersten Wert (f1) der Abschneidefrequenz; und
- Bestimmen (140, 150), ob der optische Code dekodiert wurde, **dadurch gekennzeichnet, daß** das Verfahren desweiteren in dem Fall, daß der optische Code nicht dekodiert wurde, umfaßt:

  - Aktualisieren (160) der Abschneidefrequenz (fc) in der Datenverarbeitungsschaltung (63) und Implementieren eines zweiten Wertes (f2) der Abschneidefrequenz (fc), wobei der zweite Wert (f2) niedriger ist als der erste Wert (f1);
  - Durchführen (170) zumindest eines Lesezyklus des optischen Codes mit dem zweiten Wert (f2) der Abschneidefrequenz; und
  - Bestimmen (190, 200), ob der optische. Code decodiert wurde, und, falls der optische Code nicht decodiert wurde:

- Aktualisieren (210) der Abschneidefrequenz (fc) in der Datenverarbeitungsschaltung (63) und Implementieren eines dritten Wertes (f3) der Abschneidefrequenz, wobei der dritte Wert niedriger ist als der zweite Wert (f2).

2. Verfahren nach Anspruch 1, **gekennzeichnet durch** die Schritte:

- Durchführen (220) zumindest eines Lesezyklus des optischen Codes mit dem dritten Wert (f3) der Abschneidefrequenz; und
- Bestimmen (240, 250), ob der optische Code dekodiert wurde, und, falls der optische Code nicht decodiert wurde:

  - Aktualisieren (260) der Abschneidefrequenz (fc) in der Datenverarbeitungsschaltung (63) und Implementieren eines vierten Wertes (f4) der Abschneidefrequenz, wobei der vierte Wert (f4) niedriger ist als der dritte Wert (f3).

3. Verfahren nach Anspruch 1 oder 2, **dadurch gekennzeichnet, daß** die Durchführungsschritte (120, 170, 220, 270) und die Bestimmungsschritte (140, 150, 190, 200, 240, 250) ein iteratives Wiederholen des Lesezyklus des optischen Codes mit der jeweiligen Abschneidefrequenz (fc) und das Prüfen beinhalten, ob der optische Code decodiert wurde und dadurch, daß, wenn eine jeweilige maximale Zahl (n1, n2, n3, n4) von Lesezyklen des optischen Codes erreicht wurde, ohne daß der Code decodiert wurde, die Schritte des Aktualisierens (160, 210, 260) der Abschneidefrequenz (fc) ausgeführt werden.

4. Verfahren nach Anspruch 3, wobei die jeweiligen maximalen Zahlen (n1, n2, n3, n4) von Lesezyklen des Codes verschiedene abnehmende Werte umfassen.

5. Verfahren nach Anspruch 1 und 4, **dadurch gekennzeichnet, daß** eine erste maximale Zahl (n1) von Lesezyklen mit dem ersten Wert (f1) der Abschneidefrequenz ausgeführt wird und eine zweite maximale Zahl (n2) von Lesezyklen mit dem zweiten Wert (f2) der Abschneidefrequenz ausgeführt wird, wobei die erste maximale Zahl (n1) mehr als doppelt so groß (n1 > 2n2) als die zweite maximale Zahl (n2) ist.

6. Verfahren nach Anspruch 2 und 4, **dadurch gekennzeichnet, daß** eine zweite maximale Zahl (n2) von Lesezyklen mit dem zweiten Wert (f2) der Abschneidefrequenz ausgeführt wird, eine dritte maximale Anzahl (n3) von Lesezyklen mit dem dritten Wert (f3) der Abschneidefrequenz ausgeführt wird, und eine maximale vierte Zahl (n4) von Lesezyklen mit dem vierten Wert (f4) der Abschneidefrequenz ausgeführt wird; wobei die zweite, dritte und vierte maximale Zahl im wesentlichen gleich sind.

7. Optisches Codeslesegerät, das umfaßt:

- eine Datenmanipulationsschaltung (62, 64), die ein Analogsignal empfängt, das einen optischen Code repräsentiert;
- eine Datenverarbeitungsschaltung (63), die Signale von einem Ausgang der Datenmanipulationsschaltung empfängt und ein verarbeitetes Signal zu einer automatischen Codeleseeinrichtung zuführt;

wobei die Datenverarbeitungsschaltung (63) resistive und (66) und kapazitive (67, 68, 68b) Komponenten aufweist, die einen Tiefpaßfilter definieren;

- Steuerungsmittel (65) zum Steuern der Datenverarbeitungsschaltung (63), um eine Abschneidefrequenz (fc) des Tiefpaßfilters zu regulieren, wobei das Steuerungsmittel (65) umfaßt:

  - Einstellmittel (110) zum Implementieren eines ersten Wertes (f1) der Abschneidefrequenz (fc) des Tiefpaßfilters in der Datenverarbeitungsschaltung (63);
  - Lesemittel (120) zum Durchführen zumindest eines Lesezyklus des optischen Codes mit dem ersten Wert (f1) der Abschneidefrequenz; und
  - Prüfmittel (140, 150) zum Bestimmen, ob der optische Code decodiert wurde, **dadurch gekennzeichnet, daß** das Prüfmittel ein Aktualisierungsmittel (160) zum Modifizieren der Abschneidefrequenz (fc) in der Datenverarbeitungsschaltung (63) auswählt und einen zweiten Wert (f2) der Abschneidefrequenz implementiert, wobei der zweite Wert (f2) niedriger ist als der erste Wert (f1), falls der optische Code nicht decodiert wurde; wobei

das Steuerungsmittel (65) des weiteren umfaßt:

- Lesemittel (170) zum Durchführen zumindest eines Lesezyklus des optischen Codes mit dem zweiten Wert (f2) der Abschneidefrequenz;
- Prüfmittel (190, 200) zum Bestimmen, ob der optische Code decodiert wurde, wobei das Prüfmittel das Aktualisierungsmittel (210) zum Modifizieren der Abschneidefrequenz (fc) in der Datenverarbeitungsschaltung (63) auswählt und einen dritten Wert (f3) der Abschneidefrequenz implementiert, wobei der dritte Wert (f3) niedriger ist als der zweite Wert (f2), falls der optische Code nicht decodiert wurde.

8. Lesevorrichtung nach Anspruch 7, **dadurch gekennzeichnet, daß** das Steuerungsmittel (65) des weiteren umfaßt:

- Lesemittel (220) zum Durchführen zumindest eines Lesezyklus des optischen Codes mit dem dritten Wert (f3) der Abschneidefrequenz;
- Prüfmittel (240, 250) zum Bestimmen, ob der optische Code decodiert wurde,

wobei das Prüfmittel das Aktualisierungsmittel (260) zum Modifizieren der Abschneidefrequenz (fc) in der Datenverarbeitungsschaltung (63) auswählt und einen vierten Wert (f4) der Abschneidefrequenz implementiert, wobei der vierte Wert (f4) niedriger ist als der dritte Wert (f3), falls der optische Code nicht decodiert wurde.

9. Leseeinrichtung nach Anspruch 7 oder 8, die Wiederholungsmittel (150, 200, 250, 300) umfaßt, um den Lesezyklus des optischen Codes mit der jeweiligen eingestellten Abschneidefrequenz iterativ zu wiederholen und, wenn eine jeweilige maximale Zahl (n1, n2, n3, n4) von Lesezyklen des Codes erreicht wurde, ohne daß der Code decodiert wurde, das Aktualisierungsmittel (160, 210, 260) auszuwählen, um die Abschneidefrequenz (fc) zu modifizieren, falls der Code nicht decodiert wurde.

10. Leseeinrichtung nach einem der Ansprüche 7 bis 9, **dadurch gekennzeichnet, daß** die Steuerungsmittel Mikroprozessorsteuerungsmittel sind.

11. Leseeinrichtung nach einem der Ansprüche 7 bis 10, dadurch gekennezeichnet, daß die Datenverarbeitungsschaltung (63) Widerstandsmittel (66) umfaßt, die einen ersten Anschluß, der mit dem Ausgang der Datenmanipulationsschaltung (62) kommuniziert, und einen zweiten Anschluß umfassen, der mit zumindest einem Hauptkondensator (67) verbunden ist, wobei die Datenverarbeitungsschaltung zumindest einen Sekundärkondensator (68a, 68b), der parallel mit dem Hauptkondensator (67) verbindbar ist, und Schaltmittel (69, 70) umfaßt, die durch das Steuerungsmittel (65) betätigt werden, um den sekundären Kondensator (68a, 68b) mit der parallelen Verbindung mit dem Hauptkondensator (67) zu verbinden oder davon abzukoppeln und die Abschneidefrequenz (fc) zu modifizieren.

**Revendications**

1. Procédé de lecture d'un code optique, comprenant les étapes suivantes :

- alimenter un circuit de gestion de données (62,64) avec un signal analogique représentant le code optique ;
- alimenter un circuit de traitement de données (63) de type filtre passe-bas avec des signaux provenant d'une sortie dudit circuit de gestion de données, ce circuit de traitement de données coopérant via une sortie avec des moyens de lecture automatique de code optique ;
- mettre en oeuvre (110) dans le circuit de traitement de données (63) une première valeur (f1) d'une fréquence de coupure (fc) de ce filtre passe-bas ;
- exécuter (120) au moins un cycle de lecture du code optique avec cette première valeur (f1) de la fréquence de coupure ; et
- déterminer (140, 150) si le code optique a été décodé, **caractérisé en ce que**, dans le cas où le code optique n'a pas été décodé, le procédé comprend en outre les étapes suivantes :

  - mettre à jour (160) la fréquence de coupure (fc) dans le circuit de traitement de données (63) et mettre en oeuvre une seconde valeur (f2) de la fréquence de coupure (fc), cette seconde valeur (f2) étant plus petite que la première valeur (f1) ;
  - exécuter (170) au moins un cycle de lecture du code optique avec cette seconde valeur (f2) de la fréquence de coupure ; et
  - déterminer (190, 200) si le code optique a été décodé, et, dans le cas où le code optique n'a pas été décodé :
  - mettre à jour (201) la fréquence de coupure (fc) dans le circuit de traitement de données (63) et mettre en oeuvre une troisième valeur (f3) de la fréquence de coupure, cette troisième valeur (f3) étant plus petite que la seconde valeur (f2).

2. Procédé selon la revendication 1, **caractérisé en ce qu'**il comprend les étapes suivantes :

- exécuter (220) au moins un cycle de lecture du code optique avec la troisième valeur (f3) de la fréquence de coupure ; et
- déterminer (240, 250) si le code optique a été décodé, et, dans le cas où le code optique n'a pas été décodé :

  - mettre à jour (260) la fréquence de coupure (fc) dans le circuit de traitement de données (63) et mettre en oeuvre une quatrième valeur (f4) de la fréquence de coupure, cette valeur étant plus petite que la troisième valeur (f3).

3. Procédé selon la revendication 1 ou 2, **caractérisé en ce que** les étapes d'exécution (120, 170, 220, 270) et les étapes de détermination (140, 150, 190, 200, 240, 250) comprennent une répétition de façon itérative du cycle de lecture du code optique (fc) et une vérification si le code optique a été décodé, et **en ce que**, lorsqu'un nombre maximum respectif (n1, n2, n3, n4) de cycles de lecture est atteint sans que le code soit décodé, les étapes de mise à jour (160, 210, 260) de la fréquence de coupure (fc) sont réalisées.

4. Procédé selon la revendication 3, dans lequel les nombres maximum respectifs (n1, n2, n3, n4) de cycles de lecture du code possèdent différentes valeurs décroissantes.

5. Procédé selon les revendications 1 et 4, **caractérisé en ce qu'**un premier nombre maximum (n1) de cycles de lecture est réalisé avec la première valeur (f1) de la fréquence de coupure et un second nombre maximum (n2) de cycles de lecture est réalisé avec la seconde valeur (f2) de la fréquence de coupure; ce premier nombre maximum (n1) étant plus de deux fois supérieur (n1>2n2) au second nombre maximum (n2).

6. Procédé selon les revendications 2 et 4, **caractérisé en ce qu'**un second nombre maximum (n2) de cycles de lecture est réalisé avec la seconde valeur (f2) de la fréquence de coupure, un troisième nombre maximum (n3) de cycles de lecture est réalisé avec la troisième valeur (f3) de la fréquence de coupure, et un quatrième nombre maximum (n4) de cycles de lecture est réalisé avec la quatrième valeur (f4) de la fréquence de coupure; ces second, troisième et quatrième nombres maximum étant sensiblement égaux les uns avec les autres.

7. Lecteur de code optique comprenant :

   - un circuit de gestion de données (62, 64) pour recevoir un signal analogique représentant un code optique ;
   - un circuit de traitement de données (63) pour recevoir des signaux provenant d'une sortie du circuit de gestion de données, et pour alimenter des moyens de lecture automatique de code optique avec un signal de traitement ; le circuit de traitement de données (63) comprenant des composants résistifs (66) et capacitifs (67, 68a, 68b) définissant un filtre passe-bas ;
   - des moyens de commande (65) pour commander le circuit de traitement de données (63) de réguler une fréquence de coupure (fc) du filtre passe-bas, ces moyens de commande (65) comprenant :

   - des moyens de réglage (110) pour mettre en oeuvre dans le circuit de traitement de données (63) une première valeur (f1) de la fréquence de coupure (fc) du filtre passe-bas ;
   - des moyens de lecture (120) pour exécuter au moins un cycle de lecture du code optique avec la première valeur (f1) de la fréquence de coupure; et
   - des moyens de vérification (140, 150) pour déterminer si le code optique a été décodé ; **caractérisé en ce que**, dans le cas où le code optique n'a pas été décodé, les moyens de vérification sélectionnent des moyens de mise à jour (160) pour modifier la fréquence de coupure (fc) dans le circuit de traitement de données (63) et mettre en oeuvre une seconde valeur (f2) de la fréquence de coupure, cette seconde valeur (f2) étant plus petite que la première valeur (f1) ;

les moyens de commande (65) comprenant en outre :

   - des moyens de lecture (170) pour exécuter au moins un cycle de lecture du code optique avec la seconde valeur (f2) de la fréquence de coupure ;
   - des moyens de vérification (190, 200) pour déterminer si le code optique a été décodé; dans le cas où le code optique n'a pas été décodé, ces moyens de vérification sélectionnent des moyens de mise à jour (210) pour modifier la fréquence de coupure (fc) dans le circuit de traitement de données (63) et mettre en oeuvre une troisième valeur (f3) de la fréquence de coupure, cette troisième valeur étant plus petite que la seconde valeur (f2).

8. Lecteur selon la revendication 7, **caractérisé en ce que** les moyens de commande (65) comprennent en outre :

   - des moyens de lecture (220) pour exécuter au moins un cycle de lecture du code optique avec la troisième valeur (f3) de la fréquence de coupure ;
   - des moyens de vérification (240, 250) pour déterminer si le code optique a été décodé; dans le cas où le code optique n'a pas été décodé, ces moyens de vérification sélectionnent des moyens de mise à jour (260) pour modifier la fréquence de coupure (fc) dans le circuit de traitement de données (63) et mettre en oeuvre une quatrième valeur (f4) de la fréquence de coupure, cette quatrième valeur (f4) étant plus petite que la troisième valeur (f3).

9. Lecteur selon la revendication 7 ou 8, comprenant des moyens de réitération (150, 200, 250, 300) pour répéter de façon itérative le cycle de lecture du code optique avec les fréquences de coupure respectives et, dans le cas où le code n'a pas été décodé, lorsque respectivement un nombre maximum (n1, n2, n3, n4) de cycles de lecture du code est atteint sans que le code soit décodé, sélectionner les moyens de mise à jour (160, 210, 260) pour modifier la fréquence de coupure (fc).

10. Lecteur selon l'une quelconque des revendications 7 à 9, **caractérisé en ce que** les moyens de commande sont des moyens de commande par microprocesseur.

11. Lecteur selon l'une quelconque des revendications 7 à 10, **caractérisé en ce que** le circuit de traitement de données (63) comprend des moyens de résistance (66) ayant une première borne communicant avec la sortie du circuit de gestion de données (62), et une seconde borne connectée au moins à un condensateur principal (67) ; le circuit de traitement de données comprenant au moins un second condensateur (68a, 68b) qui peut être connecté en parallèle du condensateur principale (67), et des moyens de commutation (69, 70) actionnés par les moyens de commande (65) pour connecter ou déconnecter le second condensateur (68a, 68b) à ou de la connexion parallèle avec le condensateur principal (67) et modifier la fréquence de coupure (fc).

# Fig.1

# Fig.2

Vref

Vref₂

Vc

Fig.3

TRIG

SAMPLE & HOLD

LOW-PASS FILTER

μP

Fig.6

Fig.7

Fig.4

Fig.5

Fig. 8a

Fig. 8b

| $t$ | $t_0$ | $t_1$ | $t_2$ | ..... | ..... | ..... | ..... | ..... | ..... | ..... | $t_n$ | [s] |
|---|---|---|---|---|---|---|---|---|---|---|---|---|
| ke | $ke_0$ | $ke_1$ | $ke_2$ | ..... | ..... | ..... | ..... | ..... | ..... | ...... | $ke_n$ | [pF] |
| CVN (theoretical) | $CVN_0$ | $CVN_1$ | $CVN_2$ | ..... | ..... | ..... | ..... | ...... | ...... | ....... | $CVN_n$ | [pF] |
| CVN | $CVN_0$ | $CVN_1$ | $CVN_2$ | ..... | ...... | ....... | ...... | ..... | ...... | ...... | $CVN_n$ | [pF] |

## TABLE 1

| 69 | 70 | CAPACITANCE | CUTOFF FREQUENCY |
|---|---|---|---|
| Open | Open | 67 | $fc = f_1$ |
| Closed | Open | 67+68 | $fc = f_2$ |
| Open | Closed | 67+68 | $fc = f_3$ |
| Closed | Closed | 67+68a+68b | $fc = f_4$ |

## TABLE 2